# EUROPEAN PATENT APPLICATION

(11) **EP 3 754 721 A1**
(43) Date of publication of application: **23.12.2020**
(21) Application number: 19180719.7
(22) Date of filing: 17.06.2019
(51) Int. Cl.: H01L 29/778, H01L 21/338, H01L 29/32, H01L 21/265, H01L 21/302, H01L 29/20

(54) **SEMICONDUCTOR DEVICE AND METHOD FOR FABRICATING A WAFER**

(71) Applicant: Infineon Technologies AG, 85579 Neubiberg (DE)
(72) Inventor: BIRNER, Albert, 93051 Regensburg (DE); BRECH, Helmut, 93138 Lappersdorf (DE); TWYNAM, John, 93047 Regensburg (DE)
(74) Representative: Moore, Joanne Camilla

(57) **Abstract**

A semiconductor device includes a support layer (11) having a first surface (12) capable of supporting the epitaxial growth of at least one Group III nitride, an epitaxial Group III nitride-based multi-layer structure (13) positioned on the first surface of the support layer and a parasitic channel suppression region (14) positioned at the first surface of the support layer.

## Description

### BACKGROUND

To date, transistors used in power electronic applications have typically been fabricated with silicon (Si) semiconductor materials. Common transistor devices for power applications include Si CoolMOS®, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times. However, further improvements are desirable.

### SUMMARY

In some embodiments, a semiconductor device includes a support layer having a first surface capable of supporting the epitaxial growth of at least one Group III nitride, an epitaxial Group III nitride-based multi-layer structure positioned on the first surface of the support layer and a parasitic channel suppression region positioned at the first surface of the support layer.

In some embodiments, the parasitic channel suppression region comprises an amorphous layer or a polycrystalline layer or a high-defect density region.

In some embodiments, the parasitic channel suppression region forms the first surface of the support layer. In some embodiments, the parasitic suppression region is formed within the support layer and spaced at a distance from the first surface of the support layer by a portion of the material of the support layer.

In some embodiments, the parasitic channel suppression region further comprises implanted species, wherein the species comprise at least one of the group consisting of Ar, Kr, Xe, Ne, He, N, O, H, Fe, C, Si and Al.

In some embodiments, the semiconductor device further comprises an amorphous SiN layer arranged between the epitaxial Group III nitride-based multi-layer structure and the first surface of the support substrate.

In some embodiments, the parasitic channel suppression layer has a lateral extent that corresponds to the lateral extent of the support layer.

In some embodiments, the parasitic channel suppression layer has a lateral extent that corresponds to the lateral extent of the support layer and the parasitic channel suppression layer and the support layer extend over the entire area and lateral extent of the semiconductor device.

In some embodiments, the semiconductor device comprises at least one mesa arranged on the first surface, each mesa comprising the epitaxial Group III nitride-based multi-layer structure.

In some embodiments, the parasitic channel suppression region is further positioned at or on or in a side face of the at least one mesa.

In some embodiments, a boundary between the first surface of the support layer and the epitaxial Group III nitride-based multi-layer structure is positioned in and extends across a width of the mesa.

The parasitic channel suppression layer may have a lateral extent that corresponds to the lateral extent of the mesa and may intersect the side faces of the mesa.

In some embodiments, the semiconductor device further comprises insulating material, wherein side faces of the mesa are embedded in the insulating material.

In some embodiments, the semiconductor device comprises a second surface that opposes the epitaxial Group III nitride-based multilayer structure.

In some embodiments, the second surface comprises a second surface of the support layer and insulating material. In some embodiments, the second surface of the support layer is laterally bounded by the insulating material. The second surface of the support layer may be substantially coplanar with a second surface of the insulating material and a first surface of the mesa is substantially coplanar with a first surface of the insulating material, the second surface of the support layer opposing the first surface of the mesa and the second surface of the insulating material opposing the first surface of the insulating material.

In some embodiments, the second surface of the semiconductor device comprises a second surface of the support layer and the second surface of the support layer extends under the mesa and under the insulating material.

In an embodiment, the support layer has a thickness t and the multilayer Group III nitride structure has a thickness tₙ and t ≤ tₙ.

In some embodiments, the support layer has a thickness t and lies in the range of 0.1 µm ≤ t ≤ 20 µm, or 0.1 µm ≤ t ≤ 1 µm or 1 µm ≤ t ≤ 2 µm.

In an embodiment, a method of fabricating a semiconductor wafer is provided. The method comprises implanting species into a first surface of a wafer, the first surface being capable of supporting the epitaxial growth of at least one Group III nitride layer, and forming a treated first surface comprising a parasitic channel suppression region. The method further comprises epitaxially growing a multilayer Group III nitride structure on the treated first surface.

In an embodiment, a method of fabricating a semiconductor wafer is provided, in which the method comprises epitaxially growing a multilayer Group III nitride structure on a first surface of a wafer, the first surface being capable of supporting the epitaxial growth of at least one Group III nitride layer and implanting species into a second surface of the wafer, the second surface opposing the first surface, and forming a parasitic channel suppression region at the boundary between the first surface and the multilayer Group III nitride structure, or at the interface between the first surface and the multilayer Group III nitride structure.

The species comprise at least one of the group consisting of Ar, Kr, Xe, Ne, He, N, O, H, Fe, C, Si and Al. The species comprise ions of at least one of the group consisting of Ar, Kr, Xe, Ne, He, N, O, H, Fe, C, Si and Al.

In an embodiment, the implanting species comprises implanting species at two or more different energies, for example at two or more different energies in the range of 20 keV to 250keV. In an embodiment, the species are implanted at an energy in the range of 20 keV to 250keV with an ion implantation dose of 1e¹³cm⁻² to 5e¹⁵cm⁻² or 1e¹⁴cm⁻² to 5e¹⁵cm⁻².

In an embodiment, the method further comprises removing portions of the second surface of the wafer and reducing the thickness of the wafer to a thickness t, the multilayer Group III nitride structure having a thickness tₙ, wherein t ≤ tₙ and 0.1 µm ≤ t ≤ 20 µm, or 0.1 µm ≤ t ≤ 1 µm or 1 µm ≤ t ≤ 2 µm.

In some embodiments, the method further comprises removing portions of the multilayer Group III nitride structure to form at least one mesa arranged on the first surface, each mesa comprising the epitaxial Group III nitride-based multi-layer structure and being laterally spaced part from an adjacent mesa or mesas by a portion of the wafer. In an embodiments, species are implanted into a side face of the at least one mesa and forming a parasitic channel suppression region is positioned at the side face of the at least one mesa.

In an embodiment, the method further comprises removing portions of the first surface of the wafer such that a boundary between the first surface of the wafer and the epitaxial Group III nitride-based multi-layer structure, or an interface between the first surface of the wafer and the epitaxial Group III nitride-based multi-layer structure is positioned in and extends across a width of the mesa, and applying insulating material so that side faces of the mesa are embedded in the insulating material.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1a to 1c, illustrates semiconductor devices according to various embodiments.
Figure 2, which includes figures 2a and 2b, illustrates a method of fabricating a semiconductor wafer according to an embodiment.
Figure 3, which includes figures 3a and 3b, illustrates a method of fabricating a semiconductor wafer according to an embodiment.
Figure 4, which includes figures 4a and 4b, illustrates a method of fabricating a semiconductor wafer according to an embodiment.
Figure 5, which illustrates which includes figures 5a and 5b, illustrates a method of fabricating a semiconductor wafer according to an embodiment.
Figure 6 illustrates a semiconductor device according to an embodiment.
Figure 7, which includes figure 7a and 7b, illustrates a method of fabricating a semiconductor wafer according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AlGaN refers to an alloy described by the formula AlₓGa₍₁₋ₓ₎N, where 0 < x < 1.

In III-V semiconductor devices, such as GaAs- or GaN-based devices, formed on a foreign substrate such as silicon, a parasitic conductive channel can form at the interface between the substrate and the III-V semiconductor device. Coupling between an electrode of the device, such as a drain electrode in the case of a transistor device, and these parasitic electron or hole channels can lead to losses and limit performance.

In some III-V semiconductor devices, a III-V semiconductor multilayer structure is epitaxially grown on a support substrate comprising a different material and the III-V semiconductor multilayer structure is patterned to form a plurality of discrete mesas that are spaced from one another by regions of the support substrate. These regions of the support substrate may be filled with insulation material, for example an oxide or a nitride, that may form a substantially coplanar surface with the upper surface of the mesa. One or more devices, such as a transistor device, are formed in some or all of the mesas on the support substrate. The insulating material may also be used to reduce substrate or wafer bow which may be caused by compressive or tensile stress resulting from the difference in lattice parameter between the III-V semiconductor and the support substrate. In these types of devices, parasitic electron or hole channels may form at the interface between the III-V semiconductor and the insulating material as well as at the interface between the III-V semiconductor and the support substrate.

The present disclosure aims to reduce the effect of these parasitic charge channels by providing a parasitic channel suppression region that hinders or suppresses the mobility of charges at the boundary or at the interface between the III-V semiconductor and the foreign substrate and, if present, at the interface between the insulating material and the support substrate and/or at the interface between the insulating material and the III-V semiconductor, for example an interface formed between the side faces of a mesa formed by a multi-layer stack of III-V semiconductor layers and the insulating material.

In some embodiments, a parasitic channel suppression region is provided that is highly resistive so that free charges are prevented or hindered from moving. In these embodiments, the parasitic channel suppression provides a charge mobility reduction region. The charge mobility reduction region may include an amorphous layer or region, a polycrystalline layer or region or a high defect layer or region. The charge mobility reduction region may also include a combination of amorphous and/or polycrystalline portions.

In some embodiments, a parasitic channel suppression region is provided that reduces the charge density by providing a charge density reduction region at the boundary or at the interface between the III-V semiconductor and the foreign substrate and, if present, at the interface between the side walls of the mesas and/or at the interface between the insulation material and the substrate. The charge density reduction region may include traps for trapping free charges, thus reducing the charge density and preventing the formation of a parasitic conductive electron or hole channel.

In some embodiments, parasitic channels are suppressed using a combination of charge traps, to reduce the density of free charges, and a highly resistive region to prevent movement of free charges.

Epitaxial Group III nitride-based multilayer structures, such as those described above which are used for HEMTs, have large polarization charges and are epitaxially grown at high temperature. Consequently, the inclusion of a parasitic channel suppression region can be particularly beneficial for Group III nitride-based multilayer structures.

In Group III nitride-based transistors formed on a support substrate comprising a different material, such as silicon, a parasitic conductive electron or hole channel can form at the interface between the substrate and the Group III nitride structure. This parasitic electron or hole channel may be caused by the polarization of the Group III nitride layers to form charges and electrostatic attraction of the charges by the drain electrode of the transistor. Coupling between the drain electrode and these parasitic electron or hole channels can lead to RF losses.

In embodiments in which the Group III nitride transistor devices are formed in mesas that are embedded in an insulator, parasitic electron or hole channels may also form at the interface between the Group III nitride layers and the insulator as well as at the interface between the Group III nitride and the support substrate.

In some embodiments, any mobile charge parasitic channels that are present at the Group III nitride/substrate interface directly beneath the devices are directly physically interrupted and the charges are compensated by adjusting the composition of the layers positioned on the area of this interface, i.e. above and below the interface.

In some embodiments, the present disclosure aims to reduce the mobility of mobile charge carriers that exist in the inter-mesa regions by decoupling these parasitic charge channels from the substrate in order to achieve an improvement in efficiency.

Without being bound by theory, aspects of the present disclosure are based on the realisation that bulk and interface positive charges can also exist in the insulating regions that surround the mesas comprising the Group III nitride layers and the active transistor device structure. These fixed positive charges induce mobile negative charge in the adjacent semiconductor regions which can have the form of an electron channel in the silicon substrate and in the Group III structure near the boundaries with the insulating layers, i.e. at the side walls of the mesas. These parasitic electron channels are capacitively coupled to the drain electrode and to a conductive electrode, which is typically coupled to ground potential, on the rear side of the substrate. RF losses rise due to RF current flowing between the drain electrode and the substrate through these parasitic electron channels.

In order to reduce the RF losses and improve the efficiency of the device, in a first aspect, the present disclosure seeks to suppress the current flow in the parasitic channels by inhibiting the movement of electrons in these parasitic channels. This is achieved in some embodiments by providing a charge mobility reduction region at the boundary between the Group III nitride material and the substrate. In embodiments, in which the Group III nitride material is formed as one or more mesas on the substrate that have side faces embedded in insulation material, such as a silicon oxide, a charge mobility reduction region may also be provided at side walls of the mesas and/or at the interface between the insulation material and the substrate and, therefore. The parasitic electron channels are thought to still exit and be capacitively coupled to the drain electrode and the electrode on the rear surface of the substrate. However, the charge mobility reduction region prevents current flow through the parasitic electron channel so that RF losses do not arise.

The charge mobility reduction region may be a highly resistive region which may be formed by forming an amorphous or polycrystalline or high-defect density region at positions in which the parasitic electron channels are formed, for example at the boundary between the Group III nitride layer an the substrate and, if the Group III nitride layer has the form of a mesa, optionally further at the side walls of the Group III nitride layers of the mesa and/or at the interface between the insulating material and the substrate, for example at the surface of the substrate. The charge mobility reduction region can be formed by implantation and locally disrupt the crystallinity of the substrate and epitaxial Group III nitride layers. An increase in the drain efficiency of at least 4 to 5 % points can be achieved. Drain efficiency is the ratio of (RF output power delivered to the load)/(DC power supplied to the transistor drain terminal).

In a second aspect, the present disclosure seeks to suppress the current flow in the parasitic channels by decreasing the charge density at the regions in which these parasitic channels are formed. This is achieved by providing a charge density reduction region at the boundary between the Group III nitride layer an the substrate and, if the Group III nitride layer has the form of a mesa, optionally further at the side walls of the mesas and/or at the interface between the insulation material and the substrate. The charge density reduction region may include traps for trapping the charge, thus preventing the formation of a parasitic conductive electron or hole channel.

The charge density reduction region may be an amorphous or polycrystalline or high-defect density region formed at positions in which the parasitic electron channels are formed, for example at the boundary between the Group III nitride layer an the substrate and, if the Group III nitride layer has the form of a mesa, optionally further at the side walls of the Group III nitride layers of the mesa and/or at the interface between the insulating material and the substrate. The charge density reduction region can be formed by implantation and to locally disrupt the crystallinity of the substrate and epitaxial Group III nitride layers and form charge traps in these regions.

In some embodiments, the parasitic channel suppression region may include a combination of a high trap density for reducing the charge density and a locally increased resistivity for reducing charge mobility.

These principles may also be applied to semiconductor materials other than Group III nitrides, for example III-V semiconductor materials such as GaAs.

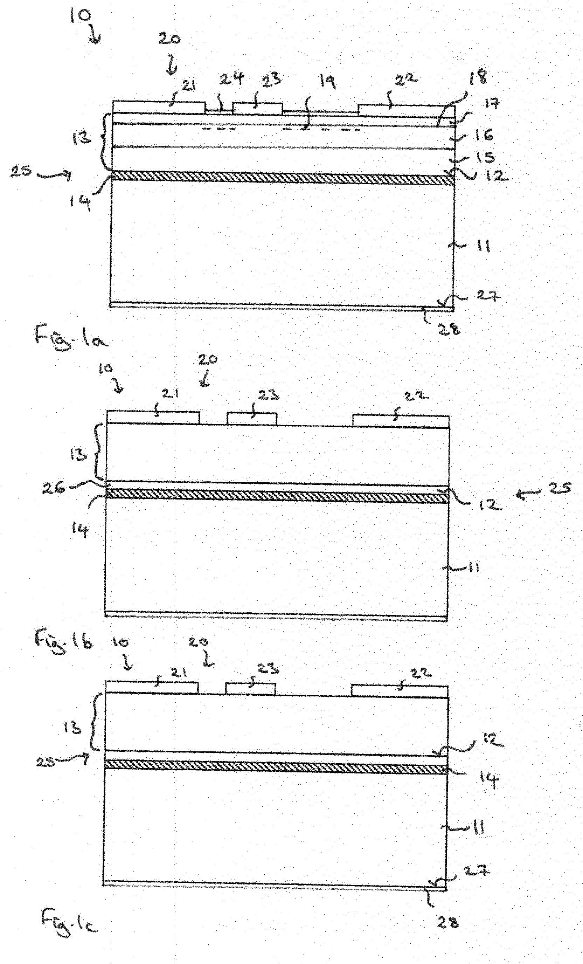

Figure 1, which includes figures 1a to 1c, illustrates semiconductor devices according to various embodiments. Each of the semiconductor devices includes at least one parasitic channel suppression region. In the following, the semiconductor device is illustrated as a Group III nitride-based semiconductor device, in particular a GaN-based semiconductor device.

Figure 1a illustrates a semiconductor device 10 which includes a support layer 11 having a first surface 12 which is capable of supporting the epitaxial growth of at least one Group III nitride. The semiconductor device 10 further includes an epitaxial Group III nitride-based multilayer structure 13 which is positioned on the first surface 12 of the support substrate 11. The semiconductor device 10 includes a parasitic channel suppression region 14 which is positioned at the first surface 12 of the support layer 11.

The support layer 11 provides a substrate for supporting the epitaxial growth of the Group III nitride-based multilayer structure 13 and may include a monocrystalline foreign substrate such as a silicon <111> or <110> wafer or a sapphire wafer or a SiC wafer or an epitaxial monocrystalline silicon layer. The support substrate 11 may be a high resistivity silicon substrate with a bulk resistivity of bulk resistivity of greater than 100 Ohm.cm, or greater than 500 Ohm.cm or greater than about 1000 Ohm.cm.

The epitaxial Group III nitride-based multilayer structure 13 may include a buffer structure, in particular, a Group III nitride buffer structure 15 which is arranged on the first surface 12 of the support substrate 11, a Group III nitride-based channel layer 16 arranged on the Group III nitride-based buffer structure 15 and a Group III nitride-based barrier layer 17 arranged on the Group III nitride-based channel layer 16. The Group III nitride-based barrier layer 17 and the Group III nitride-based channel layer 16 have differing bandgaps so that a heterojunction 18 is formed between the Group III nitride-based channel layer 16 in the Group III nitride-based barrier layer 17 which is capable of supporting a two dimensional charge gas which is indicated in figure 1a by the dashed line 19. The two dimensional charge gas may be a two dimensional electron gas (2DEG) or a two dimensional hole gas (2DHG). The Group III nitride-based channel layer 16 may be formed of GaN and the Group III nitride-based barrier layer 17 may be formed of AlGaN.

The Group III nitride-based buffer structure 15 for a silicon substrate may include an AlN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer of AlGaN back barrier is grown. Alternatively, a superlattice buffer can be used. Again an AlN starting layer on the silicon substrate is used. Depending on the chosen superlattice, a sequence of AlN and AlₓGa₍₁₋ₓ₎N pairs is grown, where the thickness of the AlN layer and AlₓGa₍₁₋ₓ₎N is in the range of 5-15nm. Depending on the desired breakdown voltage the superlattice may include between twenty and one hundred pairs. Alternatively, an AlₓGa₍₁₋ₓ₎N layer sequence as described above can be used in combination with the above mentioned superlattice.

The semiconductor device 10 may be a transistor device, for example a High Electron Mobility Transistor (HEMT), a MISFET, a MIS-HEMT or a JFET. The transistor device may have an operating frequency of 800 MHz or more. In some embodiments, the semiconductor device may be a passive device.

In the embodiments described herein, the semiconductor device 10 will be illustrated as a Group III nitride transistor device which may be a High Electron Mobility Transistor device (HEMT) 20. The HEMT 20 includes a source electrode 21 and drain electrode 22 arranged on the Group III nitride-based barrier layer 17. A gate electrode 23 is arranged laterally between the source electrode 21 and the drain electrode 22 on the Group III nitride-based barrier layer 17.

The electrodes 21, 22, 23 are however not limited to this arrangement and structure. For example, the gate electrode 23 may have a recessed structure so that the Group III nitride-based barrier layer 17 has a smaller thickness under the gate electrode 23 compared with the thickness in regions laterally outside of the gate electrode 23. Further passivation and/or insulating layers 24 may be arranged on regions of the Group III nitride-based barrier layer 17 which are uncovered by the electrodes 21, 22, 23.

In some embodiments, the source electrode 21, the gate electrode 22 and the drain electrode 23 have an elongate strip-like structure and extend substantially parallel to one another. In the cross-sectional view of figure 1, the source electrode 21, the gate electrode 22 and the drain electrode 23 extend into the plane of the drawing.

The parasitic channel suppression region 14 is positioned at the first surface 12 of the support layer 11 and at the boundary 25 between the epitaxial Group III nitride-based multilayer structure 13 and the support layer 11. The parasitic channel suppression layer may have the form of a layer having a substantially uniform thickness.

In some embodiments, the parasitic channel suppression region 14 extends continuously and uninterruptedly over the entire area of the boundary 25 and in some embodiments, extends continuously and uninterruptedly over the entire area of support layer 11 and the semiconductor device 10.

In some embodiments, such that that illustrated in figure 1a, the parasitic channel suppression region 14 forms the first surface 12 of the support layer 11 such that the Group III nitride-based multilayer structure 13 is in direct contact with the parasitic channel suppression region 14. In the embodiment illustrated in figure 1a, the Group III nitride-based buffer layer 15 is in direct contact with and epitaxially grown on the parasitic channel suppression region 14.

In some embodiments, such as that illustrated in figure 1b, a further layer or region is positioned between the parasitic channel suppression region 14 and the epitaxial Group III nitride-based multilayer structure 13. In some embodiments, the further layer is a silicon nitride layer 26 that is positioned on the first surface 12 of the support layer 11 and the epitaxial Group III nitride-based multilayer structure 13 is positioned on the silicon nitride layer 26. The silicon nitride layer 26 may be amorphous. In this embodiment, the channel parasitic channel suppression region 14 forms the first surface 12 of the support substrate 11 so that the silicon nitride layer 25 in direct contact with the parasitic channel suppression region 14 and is in direct contact with the Group III nitride-based multilayer structure 13. In some embodiments, the silicon nitride layer 26 is formed by nitridation of the first surface 12 of a silicon support substrate 11.

In some embodiments, such as that illustrated in figure 1c, the parasitic channel suppression region 14 is positioned within the support layer 11 and is spaced at a distance from the first surface 12 by an intervening region of the material of the support layer 11. In these embodiments, the first surface 12 is formed from the material of the support layer 11. In this embodiment, the Group III nitride-based multilayer structure 13 is in direct contact with the support layer 11 and with the first surface 12 of the support layer 11. The parasitic channel suppression region 14 may be spaced at a small distance from the first surface 12.

In some non illustrated embodiments, a further layer, such as an amorphous silicon nitride layer, may be formed on the first surface 13 such that it is positioned between the first surface 13 and the Group III nitride multilayer structure 15 with the parasitic channel suppression region being spaced at a distance from the first surface and being positioned within the support layer 11 as illustrated in Figure 1c.

The parasitic channel suppression region 14 may include an amorphous region or layer, a polycrystalline region or layer, a high-defect density region or layer, a region of the Group III nitride-based multi-layer structure 13 which has a damaged crystalline structure, which includes interstitial atoms or ions or charge traps or a region of support substrate 11 which has a damaged crystalline structure, which includes interstitial atoms or ions or charge traps. In some embodiments, the parasitic channel suppression region 14 further comprises implanted species, wherein implanted species comprise at least one of the group consisting of Ar, Kr, Xe, Ne, He, N, O, H, Fe, C, Si and Al. The implanted species may be ions, for example Ar⁺ ions.

In some embodiments, for example that illustrated in Figure 1c, the boundary 25 between the Group III nitride-based multilayer structure 13 and the first surface 11 of the support layer 11 or is an interface between the lowermost epitaxial Group III nitride-based layer of the epitaxial Group III nitride-based multilayer structure 13 and the first surface 12 of the support substrate 11.

In other embodiments, such that that illustrated in figure 1b, the boundary 25 has a thickness and forms a boundary region or boundary layer between the first surface 12 and the lowermost epitaxial Group III nitride-based layer. For example, the boundary 25 may include a silicon nitride layer 26 which is arranged between the first surface 12 of the substrate 11 and the lowermost epitaxial Group III nitride layer. A first interface is formed between the boundary 25 and the first surface 12 and a second interface is formed between the boundary 25 and the lowermost epitaxial Group III nitride layer.

In some embodiments, a conductive electrode 28 is arranged on the second surface 27 of the support substrate 11, the second surface 27 opposing the first surface 12. The conductive electrode 28 on the second surface 27 may be coupled to ground potential.

The parasitic channel suppression region 14 is arranged to as to suppress mobility of charges in parasitic conductive channels from the drain electrode 22 to the second rear surface 27 of the support substrate 11. These parasitic conductive channels may be formed at the boundary 25 between the Group III nitride structure 15 and the first surface 12 of the support substrate 11.

In some embodiments, the parasitic channel suppression region 14 hinders or suppresses the mobility of charges present at the interface between the Group III nitride material 13 and the support substrate 11. This can be achieved by providing a parasitic channel suppression region 14 that is highly resistive so that charges are prevented or hindered from moving. In these embodiments, the parasitic channel suppression region 14 provides a charge mobility reduction region. The charge mobility reduction region may include an amorphous layer or region, a polycrystalline layer or region or a high defect layer or region.

In some embodiments, the parasitic channel suppression region 14 hinders or suppresses the effects of a parasitic hole or electron channel by decreasing the charge density, for example by providing traps in the parasitic channel suppression region 14. As the charge density is decreased, there are fewer charges available to produce a parasitic current so that formation of a parasitic channel is suppressed.

In some embodiments, a combination of charge traps to reduce the charge density and means for hindering the flow of any free charges, such as a locally increased resistance provided by a polycrystalline, amorphous or defective crystal structure in the parasitic region 14, may be used to suppress parasitic channels.

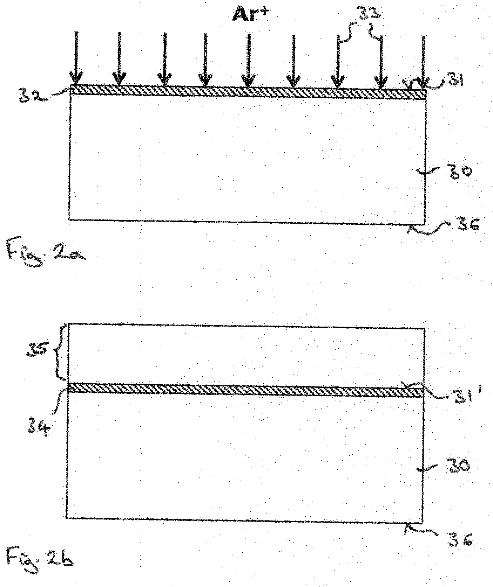

Figure 2, which includes figures 2a and 2b, illustrates a method of fabricating a semiconductor wafer 30 according to an embodiment. The method may be used to fabricate a semiconductor device with a parasitic channel suppression region according to one of the embodiments illustrated in figure 1.

The semiconductor wafer 30 includes a first surface 31 which is capable of supporting the epitaxial growth of at least one Group III nitride layer and a second surface 36 that opposes the first surface 12. The semiconductor wafer 30 may include a monocrystalline foreign substrate such as a silicon <111> or <110> wafer or a sapphire wafer or a SiC wafer or an epitaxial monocrystalline silicon layer. The semiconductor wafer 30 may be a high resistivity silicon substrate with a bulk resistivity of bulk resistivity of greater than 100 Ohm.cm, or greater than 500 Ohm.cm or greater than about 1000 Ohm.cm.

In the embodiment illustrated in figure 2, a parasitic channel suppression region 34 is formed by implanting species into the first surface 31 of the wafer 30 as is indicated schematically in figure 2a by the arrows 33. For example, the species may comprise at least one of the group consisting of Ar, Kr, Xe, Ne, He, N, O, H, Fe, C, Si and Al. The species may comprise ions of Ar, Kr, Xe, Ne, He, N, O, H, Fe, C, Si and Al, for example Ar ions. This implantation of the species into the first surface 31 creates a treated first surface 31' comprising a parasitic channel suppression region 34. The parasitic channel suppression region 34 may form the treated first surface 31' of the wafer 30 or may be positioned within the wafer 30 and be spaced at a distance from the first surface 32. The parasitic channel suppression region 34 extends continuously and uninterruptedly over the entire area of the wafer 30.

As is illustrated in figure 2b, the method may continue by epitaxially growing a multilayer Group III nitride structure 35 on the treated first surface 31'. The Group III nitride-based multilayer structure 35 may be formed by epitaxially growing a Group III nitride buffer structure on the treated first surface 31', an epitaxial Group III nitride-based channel layer on the Group III nitride-based buffer layer and an epitaxial Group III nitride-based barrier layer on the Group III nitride-based channel layer to form the structure illustrated in figure 1a, for example.

In an embodiment, the method further comprises prior to the implanting species, forming a dielectric layer on the first surface, and after implanting species, annealing at a temperature of at least 900°C and then cleaning the first surface to form a prepared first surface and afterwards epitaxially growing a first Group III nitride layer of the multi-layer Group III nitride structure on the prepared surface.

In some embodiments, one or more further layers such as a silicon nitride layer, which may be amorphous, is formed on the treated first surface 31' and then the Group III nitride-based multilayer structure 35 is formed on the further layer(s).

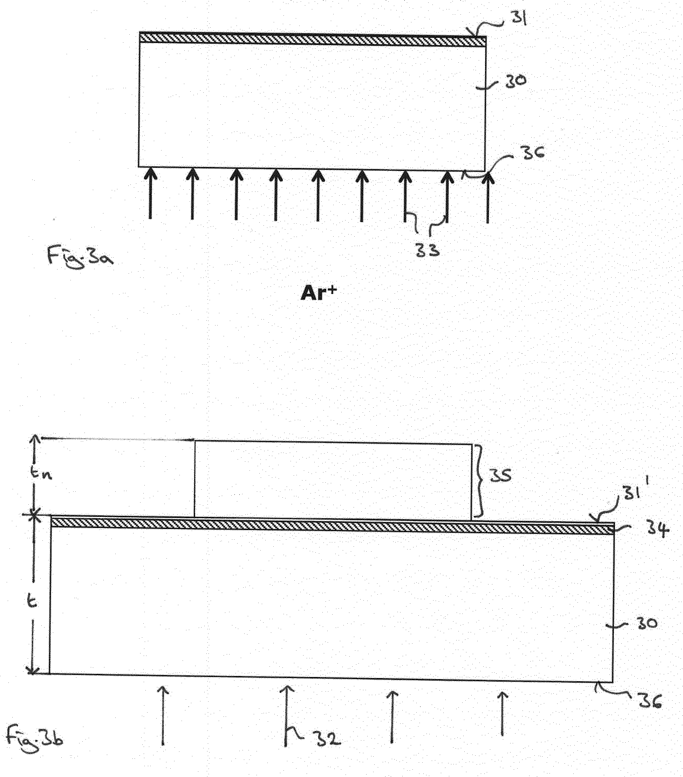

In the embodiment described with reference to figure 2, the parasitic channel suppression region 34 is formed by implanting species into the first surface 31 of the wafer 30. In other embodiments described with reference to figure 3, the parasitic channel suppression region 34 may be formed at the first surface 31 of the semiconductor wafer 30 by implanting species into the second opposing rear surface 36 of the wafer 30, as is illustrated in figure 3a.

By implanting into either the first surface 12 or into the second surface 36, the parasitic channel suppression region 34 may form the treated first surface 31 of the wafer 30 or may be positioned within the body of the wafer 30 and vertically adjacent the first surface 31 such that it is spaced apart from the first surface 31 by a portion of the material of the wafer 30. The Group III nitride-based multilayer structure 35 may then be epitaxially grown on the treated first surface 31' of the wafer 30 as illustrated in figure 3b. One or more further layers, such as a silicon nitride layer, which may be amorphous, is formed on the treated first surface 31' and then the Group III nitride-based multilayer structure 35 is formed on the further layer.

In embodiments in which the parasitic channel suppression region 34 comprises an amorphous layer or a polycrystalline layer, the parasitic channel suppression region 34 may be deposited or grown on the first surface 31 of the wafer 30 and the Group III nitride-based multilayer structure 35 is then formed on the parasitic channel suppression region 34.

The wafer 30 including the Group III nitride-based multilayer structure 35 may then be further processed to form a metallisation structure and the electrodes for a number of semiconductor devices. The individual semiconductor devices are then singulated from the wafer.

In embodiments in which the parasitic channel suppression region 34 is formed by implantation, the species may be implanted at two or more different energies. In some embodiments, the species may be implanted at two or more different energies in order to increase the implantation depth and thickness of the charge mobility reduction region 34. In particular example, the species are Ar+ ions, which are implanted at an energy in the range of 20 keV to 250 keV with an implantation dose of 1e¹³cm⁻² to 5e¹⁵cm⁻² or 1e¹⁴cm⁻² to 5e¹⁵cm⁻². In one example, the species are implanted with an ion implantation dose of 3e¹⁴cm⁻² at 50keV and 3e¹⁴cm⁻² at 250keV. The charge mobility reduction region 34 may have a polycrystalline structure or an amorphous or a high-defect density structure. Alternatively, the charge mobility reduction region 34 may be replaced by charge density reduction regions including charge traps. The charge mobility reduction regions may consist of regions of high trap density, where electrons or holes occupy the traps. In this case the number of electrons or holes available for current conduction is reduced. The resistance of the charge mobility reduction region 34 is increased due to a reduction in the density of free electrons or holes at the interface. In some embodiments, a combination of a high trap density and a polycrystalline structure or an amorphous or a high-defect density structure is used.

In some embodiments, after formation of the parasitic channel suppression region 34 and epitaxial Group III nitride multilayer structure 35, the wafer 30 may be thinned by removing portions of the second surface 36 of the wafer 30, as depicted schematically in figure 3b by the arrows 32. The thickness of the wafer 30 may be reduced to thickness t of less than 20 µm, i.e. t ≤ 20 µm. In some embodiments, the thickness of the wafer 30 may be reduced to a value of t which lies in the region of 0.1 µm ≤ t ≤ 20 µm, or 0.1 µm ≤ t ≤ 1 µm, or 1 µm ≤ t ≤ 2 µm.

In some embodiments, the entire wafer 30 may be removed by successively removing portions of the second wafer 30 to produce a layer having a second surface formed of the remaining structure, e.g. the Group III nitride-based structure 35 with the parasitic channel suppression region 34.

In some embodiments, the multilayer Group III nitride-based structure 35 has a thickness tₙ and the thickness of the thickness t of the wafer after thinning may be less than the thickness of the Group III nitride-based multilayer structure, i.e. t < tₙ. The thickness of the wafer 30 may be reduced to thickness t of less than 20 µm, i.e. t ≤ 20 µm. In some embodiments, the thickness of the wafer 30 may be reduced to a value of t which lies in the region of 0.1 µm ≤ t ≤ 20 µm, or 0.1 µm ≤ t ≤ 1 µm, or 1 µm ≤ t ≤ 2 µm.

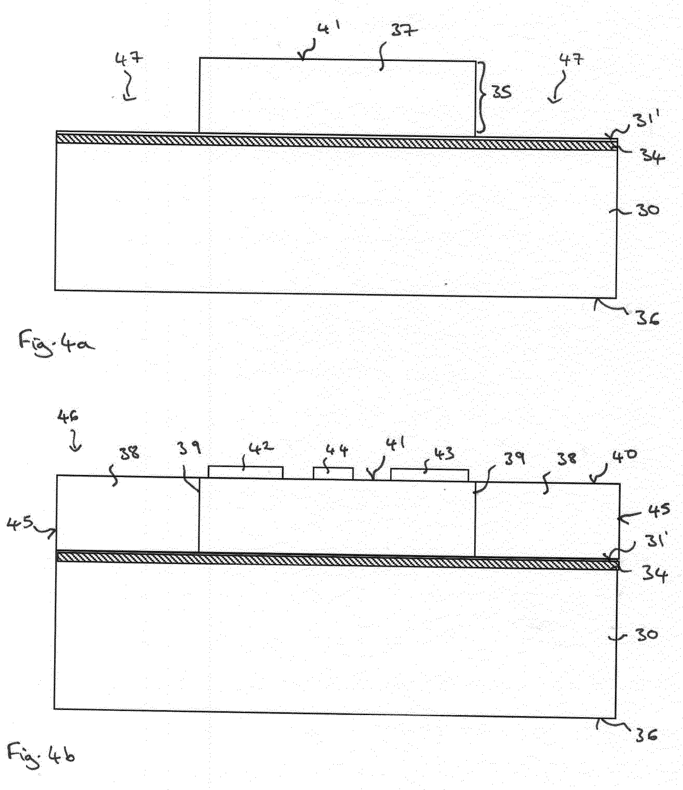

Figure 4, which includes figures 4a and 4b, illustrates a method of fabricating a semiconductor device according to an embodiment.

Figure 4a illustrates a semiconductor wafer 30 having a first surface 31 which is capable supporting the epitaxial growth of at least one Group III nitride layer and a second surface 36 which opposes the first surface 31. The semiconductor wafer further includes a parasitic channel suppression region 32 which is positioned at the first surface 31 and Group III nitride-based structure 35 has been epitaxially grown on the parasitic channel suppression region 34 on the first surface 31. The parasitic channel suppression region 34 may be formed by implantation, for example using one of the methods described with reference to figures 2 and 3 and may form the first surface 31 or be positioned within the wafer 30. The parasitic channel suppression region extends over the entire lateral area of the wafer 30 and under the entire lateral extend of the Group III nitride multilayer structure 35.

At least one mesa 37 is formed from the Group III nitride-based multilayer structure 35 by removing regions of the Group III nitride-based multilayer structure 35 such that a discrete region or island of the Group III nitride-based multilayer structure 35 remain protruding from the first surface 31 of the wafer 30 to form the mesa 37, as illustrated in figure 4a. In Figure 4, a single mesa 37 is illustrated. However, typically, a plurality of mesas are formed from the Group III nitride-based structure 35. Adjacent mesas 37 are spaced apart by exposed regions of the wafer 30 which form non-device regions 47 which define the lateral extent of each mesa 37. The height of the Group III nitride-based structure 35 determines the height of the mesa 37. In embodiments, in which the parasitic channel suppression region 34 forms the first surface 31 of the wafer 30, the parasitic channel suppression region is exposed in regions of the first surface 31 that are laterally adjacent to the mesa 37.

The mesa or mesas 37 may be formed by applying a mask to the multilayer Group III nitride structure 35 and structuring the mask to provide openings that expose regions of the Group III nitride structure 35. These exposed regions of the Group III nitride structure 35 are then removed, for example by etching, such that the first surface 31 of the wafer 30 is revealed at the base of the openings in the mask.

The proportion of the area of the Group III nitride multilayer structure 35 that is removed may be at least 10%, 50% or 80% of the area of the wafer 30.

As illustrated in figure 4b, insulating material 38 may be applied to the first surface 31 such that the side faces 39 of the mesa 37 are embedded in the insulating material 38 and such that the upper surface 40 of the insulating material 31 is substantially coplanar with the upper surface 41 of the mesa 37. The insulating material 38 may initially cover the upper surface 41 of the mesa and a planarization process be carried out, for example using chemical mechanical polishing, to form a planar surface in which the upper surface 40 of the insulating material 31 is substantially coplanar with the upper surface 41 of the mesa 37.

The insulating material 38 may include one or more layers and may include an oxide and or a nitride. For example, a nitride layer may be deposited onto the first surface 31 and an oxide layer deposited onto the nitride layer. The nitride layer may act as an etch stop in methods in which the wafer is subsequently removed from the insulating material 38. The oxide may be a silicon oxide, for example an oxide layer fabricated using a TEOS (Tetraethyl orthosilicate) process.

A metallisation structure including the source electrode 42, the drain electrode 43 and the gate electrode 44 may be formed on the upper surface 41 of the mesa 37 such that the mesa 37 provides a semiconductor device, such as a transistor device. Each mesa 37 may provide more than one semiconductor device. The parasitic channel suppression region 34 extends on or in the wafer 30 underneath both the mesa 37 and the insulating material 38. Semiconductor devices may then be singulated from the wafer such that each device includes at least one mesa 37 and the outer side faces of the devices are formed by the insulating material 38 and wafer 30.

In some embodiments, the semiconductor device 46 may have a structure corresponding to that illustrated in figure 4b and include a planar substrate provided by the wafer 30 and the parasitic channel suppression region 34 which extends over the entire width and lateral area of the device 30. The support substrate provided by the wafer 30 also extends over the entire width and lateral area of the semiconductor device 46. The side faces 45 of the semiconductor device are formed of the insulating material 38, the material of the semiconductor wafer 30 and the parasitic channel suppression region 34.

In some embodiments, for example embodiments in which the parasitic suppression channel region 34 is formed as a layer on the first surface 31 of the wafer 30, the region of the parasitic suppression channel region 34 positioned in the regions 47 may be removed from the first surface 31 so that the insulating material 38 is in direct contact with the first surface 31 and with the wafer 30.

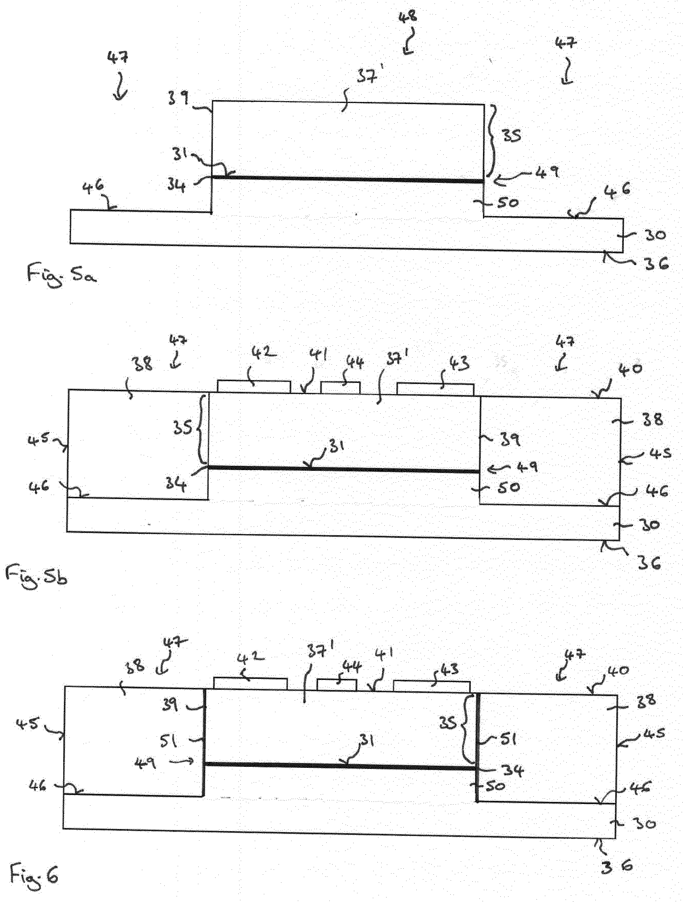

In some embodiments, such as that illustrated in figure 5a and 5b, after formation of the Group III nitride-based layer 35 and the mesa 37 from the Group III nitride-based layer 35 as illustrated in figure 4a, the first surface 31 of the wafer 30 in the region 47, which is exposed due to the removal of regions of the Group III nitride-based multilayer structure 35, is further removed to reduce the thickness of the wafer 30 in these regions 47 compared to the regions 48 of the wafer 30 positioned under the mesas 37. This forms a worked first surface 46 in the non-device regions 47 and a mesa 37' which includes the epitaxial Group III nitride-based multilayer structure 35 and a raised portion 50 of the wafer 30 which protrudes from the worked first surface 46.

The interface or boundary 49 between the Group III nitride-based multilayer structure 35 and the first surface 31 is positioned within the height of the mesa 37' and is positioned vertically above the remaining worked first surface 46 of the wafer 30. In other words, the worked first surface 46 of the non-device region 47 is positioned in a plane below that of the boundary 49 so that a protruding portion is provided which includes the mesa 37' comprising the epitaxial Group III nitride-based multilayer structure 35, the parasitic channel suppression region 34 and a raised portion 50 of the wafer 30.

The insulating material 38 is then applied to the worked first surface 46 such that it covers the side faces 39 of the mesa 37' and such that its upper surface 40 is substantially coplanar with the upper surface 41 of the mesa 37'. The insulation material 38 may initially cover the upper surface 41 of mesa 37' and the wafer may be planarised, for example by chemical mechanical polishing, so that the upper surface 40 of the insulation material 38 is substantially coplanar with the upper surface 41 of the mesa 37'. The metallisation structure including the electrodes 42, 43 and 44 may then be applied to the upper surface 41 of the mesa 37' and the semiconductor devices singulated from the wafer.

In this embodiment, the parasitic channel suppression region 34, which was formed at the first surface 31 of the wafer 30 before formation of the mesa 37', is positioned within the mesa 37' and is spaced at a distance above the worked first surface 46 the wafer 30. In these embodiments, the region of the wafer 30 which is positioned underneath the insulating material 38 and laterally adjacent to the mesa 37' may be free of a parasitic channel suppression region.

Each mesa 37' may provide a semiconductor device, such as a transistor device, for example a High Electron Mobility Transistor (HEMT), a MISFET, a MIS-HEMT or a JFET. The transistor device may have an operating frequency of 800 MHz or more. In some embodiments, the mesa 37' may provide a passive device.

In some embodiments, each mesa provides a substructure, for example a small area transistor device, which is coupled with other substructures to form a device.

In some embodiments, one or more mesas are provided which have no active or passive devices formed on or in the mesa. These mesa or mesas can be used to facilitate manufacture, e.g. by providing dummy mesa structures around the active mesa structures to aid uniform CMP (Chemical Mechanical Polishing) processing.

In some embodiments, such as that illustrated in figure 6, a further parasitic channel suppression region 51 is formed at the side faces 39 of the mesa 37, 37'. The wafer 30 may have a planar first surface that extends under both the mesa 37 and the insulation material 38 or may include a raised region 50 that forms part of the mesa 37', the raise region 50 protruding from the worked first surface 46.

The further parasitic channel suppression region 51 may be formed by implantation of species into the side faces 39 of the mesa 37' and, in present, also the side faces of the protruding portion 50 of the wafer 30.

In some embodiments, all of the side faces of the Group III nitride-based material bounded by the insulating material 38 and the lower face of the Group III nitride-based material bounded by the material of the wafer 30 include a parasitic channel suppression region 34, 51 formed such that it is in direct contact with the Group III nitride-based material and the insulating material 38 or with the Group III nitride-based material and the material of the wafer 30. In other embodiments, a parasitic channel suppression region 34, 51 is formed such that it is positioned within short distance of the Group III nitride-based material within the insulating material 38 and/or within the material of the wafer 30.

Each side face 39 of the mesa 37; 37' may be implanted separately and sequentially in order to produce a charge mobility reduction region 51 on each of the four side faces of the mesa 37'. In practice, since the support substrate 30 includes a plurality of discrete mesas 37' spaced apart by non-device regions 47 and the mesas 37' are arranged in a plurality of rows and columns, a particular side face of each of the mesa 37' on the wafer 30 is implanted using a single implantation step. The relative orientation between the mesa 37' and the implantation beam is adjusted to implant further side faces 39'.

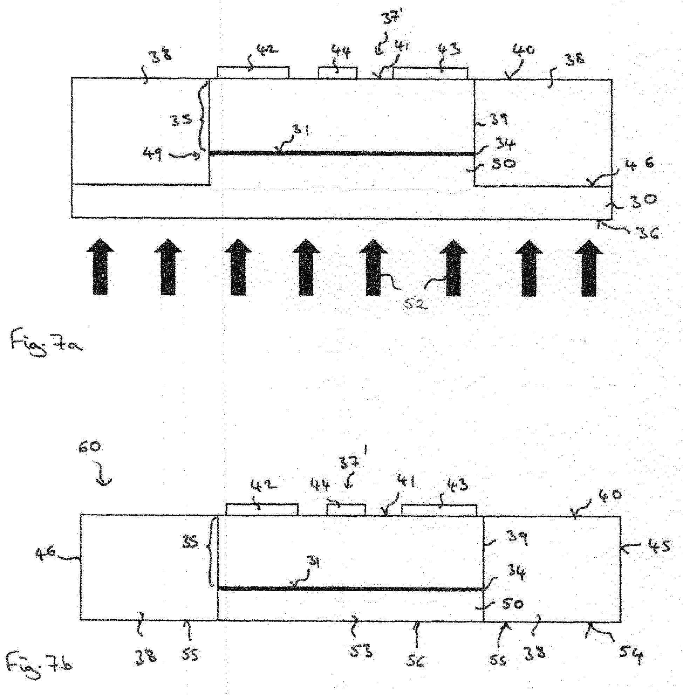

Figure 7, which includes figure 7a and 7b, illustrates a method of fabricating a semiconductor wafer according to an embodiment.

Figure 7a illustrates a semiconductor wafer 30 including a plurality of mesas 37' having side faces 39 embedded in insulating material 38. A single mesa of the plurality of mesas is seen in figure 7a.

The mesa 37' includes a Group III nitride-based multilayer structure 35 epitaxially grown on first surface 31 of a discrete raised portion 50 of the wafer 30 protruding from the worked first surface 46 of the wafer 30. The parasitic channel suppression region 34 may form the first surface 31 of the raised portion 50, may be arranged on the first surface of the raised portion 50 or may be positioned underneath the first surface 31 within the raised portion 50. The lateral extent of the parasitic channel suppression region 34 corresponds to and is substantially the same as the lateral extend of the first surface 31 of the raised portion and to the Group III nitride-based multilayer structure 35. The worked first surface 46 may not be capable of supporting the epitaxial growth of at least one Group III nitride due to the process used to remove the original first surface 31 in the regions 47 of the semiconductor wafer 30. The semiconductor wafer 30 may have the structure disclosed with reference to figures 5b or 6 for example.

In some embodiments, the thickness of the wafer 30 is then reduced by removing portions of the opposing second surface 36 of the wafer 30, for example by grinding, polishing, chemical mechanical polishing or etching as indicated schematically by the arrows 60 in figure 7a.

In some embodiments, such as that illustrated in figure 7b, the thickness of the wafer 30 is reduced such that regions of the insulating material 38 positioned laterally adjacent the mesa is 37 are exposed forming a second surface 54 which comprises discrete islands 53 of material of the wafer which are laterally bounded by insulating material 38, as illustrated in figure 7b. Individual semiconductor devices are then singulated from the wafer 30.

In embodiments in which the mesa 37' includes a raised portion 50 of the material of the wafer 30 at its base, this raised portion 50 of the wafer may remain in the second surface 53 of the final semiconductor device 60 as illustrated in figure 7b. The lower surface 55 of the insulating material 38 is substantially coplanar with the lower surface 56 of the mesa 37 in the semiconductor device 60. The side faces 45of the semiconductor device 60 are formed of the insulating material 38 only.

In embodiments, such as that illustrated in figure 4b, in which the wafer 30 providing the support substrate of the semiconductor device has a planar surface which extends throughout the lateral area of the semiconductor wafer, the thickness of the wafer may be reduced such that, in the final semiconductor device, the support substrate of the semiconductor device has a planar surface which extends throughout the lateral area of the semiconductor device. In some embodiments, in which the wafer 30 providing the support substrate of the semiconductor device has a planar surface which extends throughout the lateral area of the semiconductor wafer, substantially the entire wafer 30 could be removed such that the second surface 52 comprises the parasitic channel suppression region 34 as a discrete region that is laterally surrounded by the insulating material 38.

In the embodiments described with reference to figures 2 to 7, the charge mobility reduction region 34, 51 may be a highly resistive region which may be formed by forming an amorphous or polycrystalline region or high-defect density region at positions in which the parasitic electron channels are formed, for example between the Group III nitride-based structure 35 and the underlying material of the wafer 30 or, in embodiments including a mesa, at the interface between the side faces 39 of the mesa 37, 37' formed from the Group III nitride-based structure and the insulating material 38. The charge mobility reduction region 34, 51 can be formed by implantation and local disruption the crystallinity of the substrate 30 and/or epitaxial Group III nitride layers 35. An increase in the drain efficiency of at least 4 to 5 % can be achieved.

The charge mobility reduction layer 34, 51 serves to suppress the current flow in the parasitic channels by inhibiting the movement of electrons in these parasitic channels and reduce RF losses and increase the efficiency of the device.

The parasitic electron channels are thought to still exit and be capacitively coupled to the drain electrode 23 and the rear surface of the semiconductor device, for example with an electrode or metallic layer positioned on the rear surface of the semiconductor device. However, the charge mobility reduction region 34, 51 prevents current flow through the parasitic electron channel(s) so that RF losses do not arise.

In some embodiments, a charge density reduction region is used in addition to or in place of the charge mobility reduction region 34 to suppress parasitic channel formation or the effects of parasitic channels. A high trap density may be provided in the region 34 to reduce the charge density and as a consequence to reduce the current in the parasitic channels due to the reduction in the number of charges.

In some embodiments, the semiconductor device according to any one of the embodiments described herein may be a Monolithic Microwave Integrated Circuit (MMIC) and include at least one transistor device and at least one passive device such as a capacitor, inductor or a transmission line that is integrated into the semiconductor device, for example under the mesa 37', in the non-device regions 47, on the upper surface 41 or in the metallisation layer on the upper surface 41.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a support layer having a first surface capable of supporting the epitaxial growth of at least one Group III nitride;
an epitaxial Group III nitride-based multi-layer structure positioned on the first surface of the support layer;
a parasitic channel suppression region positioned at the first surface of the support layer.

2. A semiconductor device according to claim 1, wherein the parasitic channel suppression region comprises an amorphous layer or a polycrystalline layer or a high-defect density region.

3. A semiconductor device according to claim 1 or claim 2,
wherein the parasitic channel suppression region forms the first surface of the support layer.

4. A semiconductor device according to one of claims 1 to 3, wherein the parasitic channel suppression region further comprises implanted species, wherein the species comprise at least one of the group consisting of Ar, Kr, Xe, Ne, He, N, O, H, Fe, C, Si and Al.

5. A semiconductor device according to one of claims 1 to 4, further comprising an amorphous SiN layer arranged between the epitaxial Group III nitride-based multi-layer structure and the first surface of the support substrate.

6. A semiconductor device according to one of claims 1 to 5, wherein the semiconductor device comprises at least one mesa arranged on the first surface, each mesa comprising the epitaxial Group III nitride-based multi-layer structure.

7. A semiconductor device according to claim 6, wherein the parasitic channel suppression region is further positioned at a side face of the at least one mesa.

8. A semiconductor device according to claim 6 or claim 7, wherein an interface between the first surface of the support layer and the epitaxial Group III nitride-based multi-layer structure is positioned in and extends across a width of the mesa.

9. A semiconductor device according to one of claims 6 to 8, further comprising insulating material, wherein side faces of the mesa are embedded in the insulating material.

10. A semiconductor device according to one of claims 6 to 9, wherein the semiconductor device comprises a second surface that opposes the epitaxial Group III nitride-based multilayer structure,
wherein the second surface comprises a second surface of the support layer and insulating material, wherein the second surface of the support layer is laterally bounded by the insulating material, or
the second surface comprises a second surface of the support layer, and the second surface of the support layer extends under the mesas and under the insulating material.

11. A method of fabricating a semiconductor wafer, the method comprising:
implanting species into a first surface of a wafer, the first surface being capable of supporting the epitaxial growth of at least one Group III nitride layer, and forming a treated first surface comprising a parasitic channel suppression region,
epitaxially growing a multilayer Group III nitride structure on the treated first surface.

12. A method of fabricating a semiconductor wafer, the method comprising:
epitaxially growing a multilayer Group III nitride structure on a first surface of a wafer, the first surface being capable of supporting the epitaxial growth of at least one Group III nitride layer,
implanting species into a second surface of the wafer, the second surface opposing the first surface, and forming a parasitic channel suppression region at the interface between the first surface and the multilayer Group III nitride structure.

13. A method according to claim 11 or claim 12, wherein the implanting species comprises implanting species at two or more different energies.

14. A method according to one of claims 12 or claim 13, further comprising removing portions of the second surface of the wafer and reducing the thickness of the wafer to a thickness t, the multilayer Group III nitride structure having a thickness tₙ, wherein t ≤ tₙ and 0.1 µm ≤ t ≤ 20 µm, or 0.1 µm ≤ t ≤ 1 µm or 1 µm ≤ t ≤ 2 µm.

15. A method according to one of claims 12 to 14, further comprising:
removing portions of the multilayer Group III nitride structure to form at least one mesa arranged on the first surface, each mesa comprising the epitaxial Group III nitride-based multi-layer structure and being laterally spaced part by a portion of the wafer;
implanting species into a side face of the at least one mesa and forming a parasitic channel suppression region is positioned at the side face of the at least one mesa.

16. A method according to claim 15, further comprising:
removing portions of the first surface of the wafer such that an interface between the first surface of the wafer and the epitaxial Group III nitride-based multi-layer structure is positioned in and extends across a width of the mesa, and
applying insulating material so that side faces of the mesa are embedded in the insulating material.
